# EUROPÄISCHE PATENTANMELDUNG

(11) **EP 0 553 676 A1**
(43) Veröffentlichungstag der Anmeldung: **04.08.1993**
(21) Anmeldenummer: 93100676.1
(22) Anmeldetag: 18.01.1993
(51) Int. Cl.: H05K 3/34, B23K 3/08

(54) **Verfahren zum Bestücken von Leitplatten mit Bauelementen und Vorrichtung zur Bereitstellung von Lötflussmittel beim Bestücken von Leiterplatten mit Bauelementen**

(30) Priorität: 29.01.1992 DE 4202456
(71) Anmelder: SIEMENS AKTIENGESELLSCHAFT, D-80333 München (DE)
(72) Erfinder: Raschke, Josef, W-8011 Gelting (DE); Bloessl, Hermann, W-8000 München 70 (DE)

(57) **Zusammenfassung**

Die Bauelemente (14) werden aus Zuführeinrichtungen (20) entnommen, zu einer Platte (6) transportiert und dort derart abgesenkt, daß die Anschlußbeinchen (13) der Bauelemente (14) in einen auf der Platte (6) gebildeten Film eines Lötflußmittels (17) eintauchen. Nach diesem selektiven Auftragen des Lötflußmittels (17) auf die Anschlußbeinchen (13) werden die Bauelemente (14) in zugeordneten Bestückpositionen einer Leiterplatte (21) positioniert und aufgelötet. Zum Auflöten werden vorzugsweise Lötbügel (25) eingesetzt. Bei dem erfindungsgemäßen Verfahren und der erfindungsgemäßen Vorrichtung wird eine Verschmutzung der Leiterplatten (21) mit Lötflußmittel (17) vermieden.

## Beschreibung

Lötvorrichtungen mit zwei parallel einander gegenüberliegenden Bügelelektroden oder mit vier paarweise einander gegenüberliegenden Bügelelektroden werden insbesondere für das Auflöten hochpoliger elektronischer Bauelemente, wie Mikropacks, Flatpacks und dgl. eingesetzt, wobei die Widerstandserwärmung der Bügelelektroden in der Regel durch Stromimpulse vorgenommen wird.

Es ist auch bereits bekannt, Lötvorrichtungen mit zwei oder vier Bügelelektroden an einem verfahrbaren Kopf anzubringen, der zusätzlich noch mit einer Saugpipette ausgerüstet ist (DE-Z Feinwerktechnik & Meßtechnik 96, 1988, Heft 9, S. 387-389). Die Saugpipette entnimmt aus einer Zuführeinrichtung ein Bauelement und positioniert es dann in einer vorgegebenen Bestückposition auf der Leiterplatte. Danach werden die Lötbügel auf die Anschlußbeinchen des Bauelements abgesenkt und zum Auflöten der Anschlußbeinchen auf die zugeordneten Lötstellen der Leiterplatte erwärmt.

Um beim Lötvorgang eine Reduktion der Oxide zwischen den zu verbindenden Teilen zu bewirken, werden vor dem Positionieren der Bauelemente auf die Lötstellen der Leiterplatten Lötflußmittel aufgebracht. Ein selektives Aufbringen des Lötflußmittels auf die Lötstellen ist dabei jedoch nicht möglich. Beim Aufbringen des Lötflußmittels durch Sprühen oder dgl. ergibt sich vielmehr eine Verschmutzung des Umfelds der zu bestückenden Flächen und der dort befindlichen Teile.

Der Erfindung liegt das Problem zugrunde, beim Aufbringen und Auflöten von Bauelementen auf Leiterplatten das für die Lötung erforderliche Flußmittel nur im Bereich der Lötstellen aufzubringen und eine Verschmutzung der Umgebung mit Lötflußmittel zu verhindern.

Dieses Problem wird mit den Maßnahmen des Anspruchs 1 oder des Anspruchs 2 gelöst.

Der Erfindung liegt die Erkenntnis zugrunde, daß das Lötflußmittel nicht wie herkömmlich auf die Lötflächen der Leiterplatten, sondern auf die Anschlußbeinchen der Bauelemente aufgebracht werden sollte und hierzu die Anschlußbeinchen lediglich in einen auf einer Platte gebildeten Film des Lötflußmittels eingetaucht werden müssen. Mit dem Eintauchen der Anschlußbeinchen in einen Film des Lötflußmittels ist mit einem Minimum an Aufwand gewährleistet, daß das Lötflußmittel nur dort zur Verfügung gestellt wird, wo es für den Lötvorgang benötigt wird.

Vorteilhafte Ausgestaltungen der erfindungsgemäßen Vorrichtung zur Bereitstellung von Lötflußmittel sind in den Ansprüchen 3 bis 10 angegeben.

Die Ausgestaltung nach Anspruch 3 bietet die Möglichkeit, unabhängig von der Form der Anschlußbeinchen, eine Benetzung des Körpers der Bauelemente mit Lötflußmittel sicher zu verhindern. Gemäß Anspruch 4 kann diese Maßnahme auch für Bauelemente mit verschiedener Geometrie vorgenommen werden.

Die Ausgestaltung nach Anspruch 5 bietet die Möglichkeit einer Erhöhung der Schichtdicke des Lötflußmittels im Umfangsbereich der Öffnung. Hierdurch können die Anschlußbeinchen sicher in das Lötflußmittel eingetaucht werden, ohne mit der Platte in Kontakt zu kommen. Ein durch einen derartigen Kontakt mögliches Verdrehen der Bauelemente kann damit mit Sicherheit ausgeschlossen werden.

Die Weiterbildung nach Anspruch 6 ermöglicht auf besonders einfache Weise eine Ergänzung bzw. Erneuerung des Lötflußmittelfilms auf der Platte.

Die Ausgestaltung nach Anspruch 7 schafft eine definierte Lage der ortsfest angeordneten Platte und der Öffnungen, so daß die Bauelemente dann auch exakt über den zugeordneten Bereichen der Platte positioniert werden können.

Die Weiterbildung nach Anspruch 8 ermöglicht eine einfache und zuverlässige Abdichtung des Vorratsbehälters.

Gemäß Anspruch 9 kann das Heben und Senken des Vorratsbehälters mit geringem Aufwand mit Hilfe eines Kurbeltriebes vorgenommen werden.

Die Ausgestaltung nach Anspruch 10 ermöglicht einen einfachen Schutz des Lötflußmittels vor Verdunstung und Verschmutzung. Durch die im Anspruch 11 angegebenen Maßnahmen wird dabei ein selbsttätiges Öffnen des Vorratsbehälters im Bedarfsfall gewährleistet.

Ein Ausführungsbeispiel der Erfindung ist in der Zeichnung dargestellt und wird im folgenden näher beschrieben.

Es zeigen:
Figur 1 die wesentlichen Verfahrensschritte beim Aufbringen und Auflöten von Bauelementen auf Leiterplatten,
Figur 2 und Figur 3 zwei verschiedene Seitenansichten einer erfindungsgemäßen Vorrichtung zur Bereitstellung von Lötflußmittel beim Bestücken von Leiterplatten,
Figur 4 einen Schnitt durch die in den Figuren 2 und 3 dargestellte Vorrichtung,
Figur 5 und Figur 6 den definierten Auftrag eines Lötflußmittels auf die Anschlußbeinchen eines Bauelements im Detail,
Figur 7 eine Draufsicht auf eine Platte für die Bereitstellung von Lötflußmittel,
Figur 8 eine Variante der in Figur 7 dargestellten Platte und
Figur 9 einen Schnitt gemäß der Linie IX - IX der Figur 8.

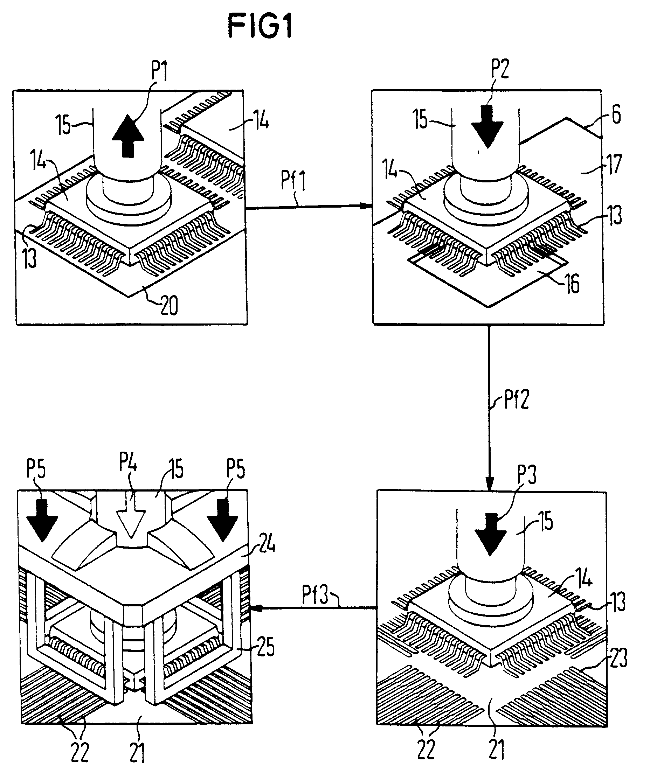

Figur 1 zeigt zunächst links oben die Entnahme eines mit einer Vielzahl von Anschlußbeinchen 13 versehenen Bauelements 14 aus einer Zuführeinrichtung 20. Hierzu wird die Saugpipette 15 eines nicht näher dargestellten verfahrbaren Kopfes auf das in der Entnahmeposition befindliche Bauelement 14 abgesenkt, worauf dieses Bauelement 14 angesaugt und in Richtung des Pfeiles P1 angehoben wird. Danach wird das Bauelement 14 zu einer rechts oben dargestellten Vorrichtung zur Bereitstellung von Lötflußmittel transportiert, wobei der Verfahrweg des Kopfes durch einen Pfeil Pf1 angedeutet ist. Die Vorrichtung zur Bereitstellung von Lötflußmittel umfaßt eine Platte 6, auf deren Oberfläche ein Film des Lötflußmittels 17 gebildet ist. Die Saugpipette 15 mit dem Bauelement 14 wird in Richtung des Pfeiles P2 derart abgesenkt, daß die Anschlußbeinchen 13 in das Lötflußmittel 17 auf der Platte 6 eintauchen und damit benetzt werden. Eine Benetzung des Körpers des Bauelements 14 mit Lötflußmittel 17 wird durch eine in Form und Größe auf den Körper abgestimmte Öffnung 16 der Platte 6 verhindert.

Nach dem selektiven Aufbringen des Lötflußmittels 17 auf die Anschlußbeinchen 13 wird die Saugpipette 15 mit dem Bauelement 14 in die rechts unten dargestellte Bestückposition einer Leiterplatte 21 verfahren und in Richtung des Pfeiles P3 abgesenkt. Bei diesem Positioniervorgang werden die Anschlußbeinchen 13 exakt auf zugeordneten Lötstellen 23 angeordnet, die sich jeweils am Ende einer Leiterbahn 22 auf der Leiterplatte 21 befinden. Nach diesem Positionieren des Bauelements 14 erfolgt dann das links unten dargestellt Auflöten der Anschlußbeinchen 13 auf die zugeordneten Lötstellen 23. Da der Kopf mit der Saugpipette 15 hierzu nicht mehr verfahren wird, deutet der Pfeil Pf3 hier das Absenken einer ebenfalls am Kopf befestigten Lötbügelanordnung an, die einen Lötbügelhalter 24 und vier paarweise einander gegenüberliegende Lötbügel 25 umfaßt. Die Anschlußbeinchen 13 werden über die Bügelelektroden 25 gegen die Lötstellen 23 gedrückt, wobei die entsprechende Andruckkraft durch Pfeile P5 angedeutet ist. Auch die Saugpipette 15 drückt das Bauelement 14 mit einer geringen Kraft gegen die Leiterplatte 21, wobei diese durch einen Pfeil P4 angedeutete Kraft während des gesamten Lötvorganges gehalten wird.

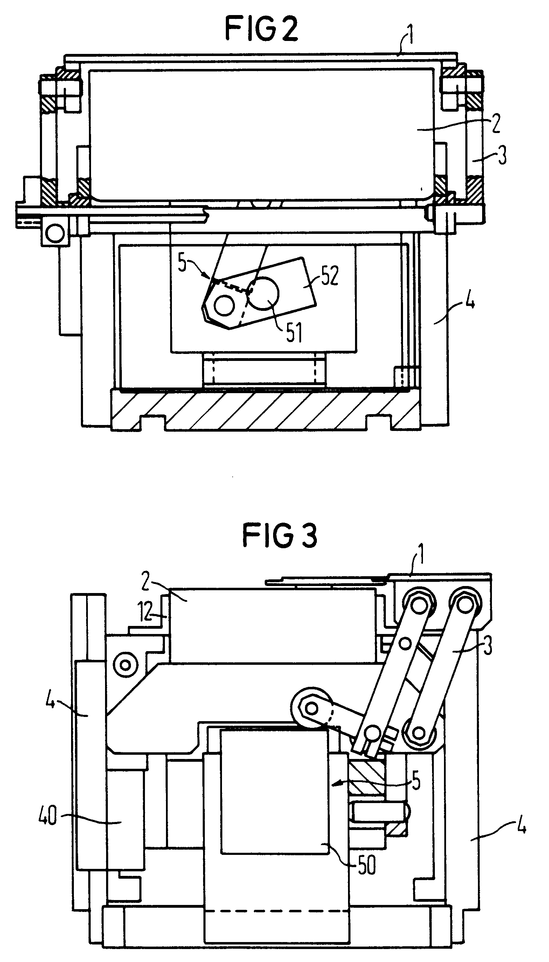

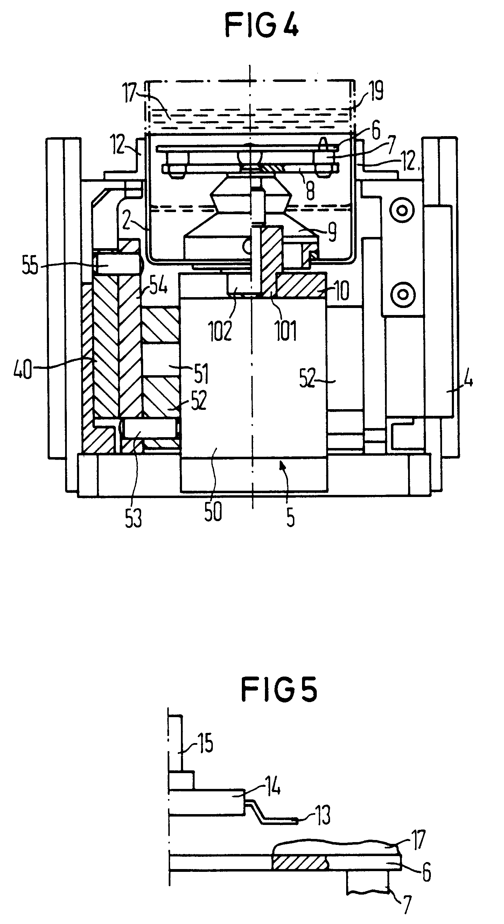

Die in Figur 1 rechts oben rein schematisch dargestellte Vorrichtung zur Bereitstellung von Lötflußmittel mit dem auf einer Platte 6 gebildeten Film des Lötflußmittels 17 wird nachfolgend unter Hinweis auf die Figuren 2, 3 und 4 erläutert. Die Platte 6 liegt auf Zentrierzapfen 7, welche ihrerseits mit einer Trägerplatte 8 und einer stationären Konsole 10 verbunden sind. Die Verbindung zwischen der Konsole 10 und der Trägerplatte 8 erfolgt dabei über ein in Figur 4 erkennbares Zylinderstück 101 und einen darin angeordneten Tragzapfen 102.

Die Platte 6 und die Trägerplatte 8 befinden sich innerhalb eines heb- und senkbaren Vorratsbehälters 2 für Lötflußmittel 17, wobei die Abdichtung zwischen der Trägerplatte 8 und dem Boden des Vorratsbehälters 2 über eine elastische Manschette 9 erfolgt, welche das Zylinderstück 101 und den Tragzapfen 102 umschließt.

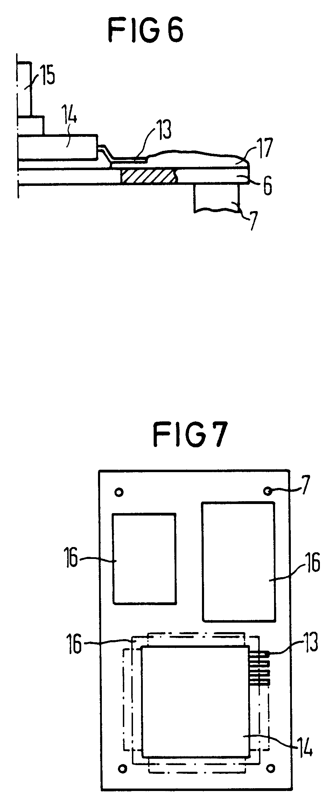

Zum Heben und Senken des Vorratsbehälters 2 ist ein insgesamt mit 5 bezeichneter Kurbeltrieb vorgesehen, dessen pneumatischer Drehzylinder 50 eine Welle 51 antreibt, auf welcher auf einander gegenüberliegenden Seiten jeweils eine Kurbel 52 angeordnet ist. Jede dieser beiden Kurbeln 52 treibt jeweils über einen ersten Zapfen 53 eine Kurbelstange 54 an, wobei die Kurbelstangen 54 jeweils über zweite Zapfen 55 auf das vertikal bewegliche Teil 40 einer insgesamt mit 4 bezeichneten Längsführung einwirken. Die vertikal beweglichen Teile 40 der beiden Längsführungen 4 sind jeweils über einen Winkel 12 mit dem Vorratsbehälter 2 verbunden, so daß der Vorratsbehälter 2 über den pneumatischen Drehzylinder 50 zwischen einer unteren Stellung und einer oberen Stellung verfahren werden kann. In der in Figur 4 durch strichpunktierte Linien 19 angedeuteten oberen Stellung des Vorratsbehälters 2 ist die Platte 6 vollständig im Lötflußmittel 17 eingetaucht. Beim Absenken des Vorratsbehälters 2 in die in der Zeichnung dargestellte untere Sellung wird der Badspiegel so weit abgesenkt, daß die Platte 6 vollständig frei ist und nur noch an ihrer Oberseite ein je nach Viskosität bis zu 1 mm starker Film des Lötflußmittels 17 verbleibt. Gleichzeitig mit dem Absenken des Vorratsbehälters 2 wird dessen Abdeckung 1 selbsttätig durch eine insgesamt mit 3 bezeichnete Vorrichtung geöffnet. Nach dem Öffnen der Abdeckung 1 kann dann entsprechend dem in Figur 1 rechts oben dargestellten Vorgang die Saugpipette 15 mit einem Bauelement 14 auf die Platte 6 abgesenkt werden. Der definierte Auftrag des Lötflußmittels 17 auf die Anschlußbeinchen 13 eines Bauelements 14 ist dann in den Figuren 5 und 6 im Detail dargestellt. Gemäß Figur 5 wird die Saugpipette 15 mit dem Bauelement 14 zunächst derart oberhalb der Platte 6 positioniert, daß sich der Körper des Bauelements 14 genau oberhalb der zugeordneten Öffnung 16 der Platte 6 befindet. Gemäß Figur 6 wird dann die Saugpipette 15 abgesenkt, bis die Anschlußbeinchen 13 in den Film des Lötflußmittels 17 eintauchen. Die Anschlußbeinchen 13 befinden sich dabei in einer definierten Höhe oberhalb der Oberfläche der Platte 6.

Figur 7 zeigt eine Draufsicht auf eine Platte 6 mit insgesamt drei Öffnungen 16, die in Form und Größe auf die Körper der zugeordneten Bauelemente 14 abgestimmt sind. Die genaue Positionierung der Bauelemente 14 über den jeweils zugeordneten Öffnungen 16 erfolgt über die Saugpipette 15 (vgl. Figuren 1, 5 und 6).

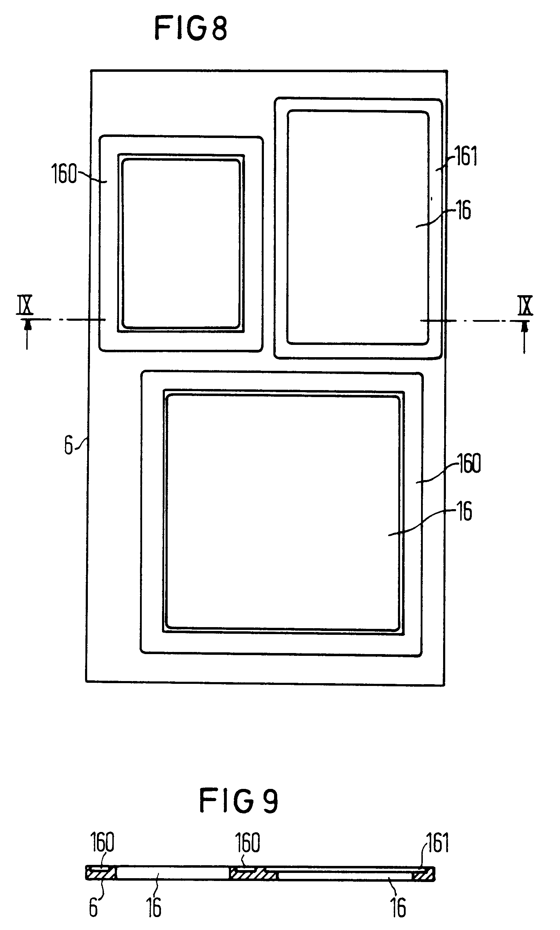

Die Figuren 8 und 9 zeigen in einem größeren Maßstab eine Variante der in Figur 7 dargestellten Platte 6. Bei dieser Variante sind die linke obere Öffnung 16 und die untere Öffnung 16 von U-förmigen Vertiefungen 160 umgeben, die unmittelbar im Umfangsbereich in die Platte 6 eingebracht sind. Die den Anschlußbeinchen 13 der Bauelemente 14 (vgl. Fig. 6) zugeordneten Vertiefungen 160 bewirken eine Erhöung der Schichtdicke des Lötflußmittels 17 (vgl. Fig. 6) in diesem Bereich. Die im Umfangsbereich der rechten oberen Öffnung 16 vorgesehene Vertiefung 161 ist zur Platte 16 hin offen. Damit eignet sich die Vertiefung 161 für Bauelemente, deren Anschlußbeinchen in Höhe des Körpers der Bauelemente liegen. Eine Benetzung des Körpers der Bauelemente mit Lötflußmittel wird dabei mit Sicherheit vermieden.

## Patentansprüche

1. Verfahren zum Bestücken von Leiterplatten (21) mit Bauelementen (14), bei welchem die Bauelemente (14) aus Zuführeinrichtungen (20) entnommen, in vorgegebenen Bestückpositionen auf den Leiterplatten (21) positioniert und dann unter Verwendung eines Lötflußmittels (17) mit ihren Anschlußbeinchen (13) auf die zugeordneten Lötstellen (23) der Leiterplatten (21) aufgelötet werden,
**dadurch gekennzeichnet,**
daß die Anschlußbeinchen (13) der Bauelemente (14) auf dem Weg (Pf1, Pf2) zwischen Zuführeinrichtungen (20) und Leiterplatten (21) in einen auf einer Platte (6) gebildeten Film des Lötflußmittels (17) eingetaucht werden.

2. Vorrichtung zur Bereitstellung von Lötflußmittel (17) beim Bestücken von Leiterplatten (21) mit Bauelementen (14),
**gekennzeichnet durch**
eine Platte (6) und einen auf der Platte gebildeten Film des Lötflußmittels (17).

3. Vorrichtung nach Anspruch 2,
**dadurch gekennzeichnet,**
daß in die Platte (6) eine Öffnung (16) eingebracht ist, deren Form und Größe auf den Körper eines Bauelements (14) abgestimmt ist.

4. Vorrichtung nach Anspruch 3,
**dadurch gekennzeichnet,**
daß in die Platte (6) mehrere, verschiedenen Bauelementen (14) zugeordnete Öffnungen (16) eingebracht sind.

5. Vorrichtung nach Anspruch 3 oder 4,
**dadurch gekennzeichnet,**
daß im Umfangsbereich der Öffnung (16) eine den Anschlußbeinchen (13) der Bauelemente (14) zugeordnete Vertiefung (160, 161) in die Platte (6) eingebracht ist.

6. Vorrichtung nach einem der Ansprüche 2 bis 5,
**dadurch gekennzeichnet,**
daß die Platte (6) ortsfest in einem heb- und senkbaren Vorratsbehälter (2) für Lötflußmittel (17) angeordnet ist.

7. Vorrichtung nach Anspruch 6,
**dadurch gekennzeichnet,**
daß die Platte (6) auf Zentrierzapfen (7) angeordnet ist, die mit einer Trägerplatte (8) und einer ortsfesten Konsole (10) verbunden sind.

8. Vorrichtung nach Anspruch 7,
**dadurch gekennzeichnet,**
daß zur Abdichtung zwischen Trägerplatte (8) und Vorratsbehälter (2) eine elastische Manschette (9) vorgesehen ist.

9. Vorrichtung nach einem der Ansprüche 6 bis 8,
**dadurch gekennzeichnet,**
daß zum Heben und Senken des Vorratsbehälters (2) ein Kurbeltrieb (5) vorgesehen ist.

10. Vorrichtung nach einem der Ansprüche 6 bis 8,
**dadurch gekennzeichnet,**
daß der Vorratsbehälter (2) durch eine Abdeckung (1) verschließbar ist.

11. Vorrichtung nach Anspruch 10,
**gekennzeichnet durch**
eine Vorrichtung (3) zum selbsttätigen Öffnen der Abdeckung (1) beim Senken des Vorratsbehälters (2).
